# EUROPEAN PATENT APPLICATION

(11) **EP 3 349 549 A1**
(43) Date of publication of application: **18.07.2018**
(21) Application number: 17151094.4
(22) Date of filing: 11.01.2017
(51) Int. Cl.: H05K 1/11, H05K 3/32, H01R 12/58, H05K 1/02

(54) **SOLDERLESS JOINT ARRANGEMENT**

(71) Applicant: Itron Global SARL, Liberty Lake WA 99019 (US)
(72) Inventor: BOTTNER, Michel, Liberty Lake, WA Washington 99019 (US); CATHERIN, Daniel, Libery Lake, WA Washington 99019 (US); HYVERNAT, Stéphane, Liberty Lake, WA Washington 99019 (US)
(74) Representative: Morrall, Jonathan Ian McLachlan

(57) **Abstract**

A solderless joint arrangement comprising a receptacle (11, 12) of a PCB (10) arranged to receive a conductive compliant pin, the receptacle (11) comprising a conductive portion (12) for contact with the compliant pin wherein the receptacle is positioned on a flexible portion (20) of the PCB.

## Description

This invention relates to providing a solderless and reliable electrical connection. It is particularly suitable for, but not limited to use with a compliant pin of a utility meter.

### Background

Solderless electrical connections may be formed by way of a number of techniques. One such technique comprises a conductive element being positioned in a through-hole of a PCB. The through-hole, sometimes known as a via, is typically plated so that a conductive surface is presented to the conductive element as it enters the through-hole. A portion of the conductive element is usually slightly oversized for the diameter of the through-hole. Deformation of either the oversized portion of the conductive element or the through-hole is therefore required in order for the conductive element to be positioned in the through-hole. This provides a good and reliable contact between the conductive element and the plated surface of the through-hole. The goal is a gas-tight solderless connection.

Such a solderless connection allows the connection in question to be manufactured without a heat-cycle usually associated with the formation of a soldered joint. This simplifies manufacture and is aimed at improving reliability of the PCB as a whole.

When a solderless joint is formed, the contact point where the deformation of either the conductive element or the plated through-hole occurs can cause oxidation film on the plated through-hole surface to be broken. This is known as fretting. If the solderless contact surface were to move again, perhaps due to movement of either the PCB comprising the plated through-hole or the conductive element, the friction of the solderless contact point can cause additional fretting of the oxidation film at a different contact point on the plated through-hole surface. The original contact point is then exposed to oxygen in the air, and a new layer of tin oxide will form at the original contact point. This is corrosion, and hence the mechanism of contact point movement and additional tin oxide being formed is collectively known as fretting corrosion.

Each repetition of fretting corrosion forms additional tin oxide debris in the general area of the plated-through-hole. As the debris increases, it will interfere with the contact point(s) such that contact resistance will increase. Eventually, the contact will be affected by such a degree that the solderless joint becomes electrically unreliable.

Accordingly, there is a need to provide a more reliable solderless joint.

### Summary

According to a first aspect there is provided a solderless joint arrangement as defined in Claim 1 of the appended claims. Thus there is provided a solderless joint arrangement comprising a receptacle of a PCB arranged to receive a conductive compliant pin, the receptacle comprising a conductive portion for contact with the compliant pin wherein the receptacle is positioned within a flexible portion of the PCB.

Optionally, the receptacle comprises a plated through-hole.

Optionally, the flexible portion of the PCB is arranged to be flexible in at least one of the x, y and/or z axis.

Optionally, the flexible portion of the PCB is arranged to be flexible in each of the x, y and z axis.

Optionally, the flexible portion comprises drill holes to provide flexibility of the PCB.

Optionally, the flexible portion comprises cuts to provide flexibility of the PCB

Optionally, the flexible portion comprises a spiral shape cut to the PCB to provide flexibility of the PCB.

Optionally, the flexible portion comprises the removal of at least one layer of the PCB to provide flexibility of the PCB.

Optionally, the solderless joint further comprising a conductive compliant pin positioned within the receptacle, the conductive compliant pin comprising an interconnection end arranged to complete the solderless joint with the conductive portion of the receptacle and a piezo interface end arranged to interface with a piezo transducer for communication of an ultrasonic signal to the conductive portion.

Optionally, the interconnection end of the conductive compliant pin comprises a press-fit arrangement to interconnect with the conductive portion of the PCB.

Optionally, the conductive compliant pin comprises two portions, a first portion comprising the interconnection end of the conductive compliant pin and a second portion comprising the piezo interface end of the conductive compliant pin, wherein the second portion comprises a thickness less than the first portion.

Optionally, the piezo interface end of the conductive compliant pin comprises a C-shape contact arranged to contact a piezo transducer

Optionally, the C-shape contact may contact the piezo transducer substantially in the centre of the piezo transducer.

Optionally, the first portion and the second portion of the conductive compliant pin are joined by one of riveting, clinching, laser welding or ultrasonic welding.

Optionally, the conductive compliant pin comprises the same thickness throughout its length.

Optionally, the piezo interface end of the conductive compliant pin comprises a ring-shape contact arranged to contact a piezo transducer substantially at the periphery of the piezo transducer.

According to a second aspect there is provided a water meter comprising the solderless joint according to the first aspect.

According to a third aspect there is provided a method of providing a solderless joint arrangement, the method comprising providing a PCB with a receptacle for receiving a compliant pin, the receptacle comprising a conductive portion for contact with the compliant pin; wherein the receptacle is positioned within a flexible portion of the PCB.

Optionally, the method wherein the receptacle comprises a plated through-hole.

Optionally, the method wherein the flexible portion of the PCBis arranged to be flexible in at least one of the x, y and/or z axis.

Optionally, the method wherein the flexible portion of the PCB is arranged to be flexible in each of the x, y and z axis.

Optionally, the method further comprising providing drill holes in the flexible portion to provide flexibility of the flexible portion.

Optionally, the method further comprising cutting the flexible portion to provide flexibility of the flexible portion.

Optionally, the method further comprising cutting the PCB in a spiral-shape to provide flexibility of the flexible portion.

Optionally, the method further comprising removing at least one layer of the PCB to provide flexibility of the flexible portion.

Optionally, the method further comprising positioning a conductive compliant pin within the receptacle, the conductive compliant pin comprising an interconnection end arranged to complete the solderless joint with the conductive portion of the receptacle and a piezo interface end arranged to interface with a piezo transducer for communication of an ultrasonic signal to the conductive portion.

Optionally, the method wherein the interconnection end of the conductive compliant pin comprises a press-fit arrangement to interconnect with the conductive portion of the PCB.

Optionally, the method wherein the conductive compliant pin comprises two portions, a first portion comprising the interconnection end of the conductive compliant pin and a second portion comprising the piezo interface end of the conductive compliant pin, wherein the second portion comprises a thickness less than the first portion.

Optionally, the method wherein the piezo interface end of the conductive compliant pin comprises a C-shape contact arranged to contact a piezo transducer.

Optionally the C-shape may contact the piezo transducer substantially in the centre of the piezo transducer.

Optionally, the method further comprising joining the first portion and the second portion of the conductive compliant pin by one of riveting, clinching, laser welding or ultrasonic welding.

Optionally, the method wherein the conductive compliant pin comprises the same thickness throughout its length.

Optionally, the method wherein the piezo interface end of the conductive compliant pin comprises a ring-shape contact arranged to contact a piezo transducer substantially at the periphery of the piezo transducer.

According to a fourth aspect there a conductive compliant pin comprising an interconnection end arranged to complete a solderless joint with a conductive portion of a PCB receptacle and a piezo interface end arranged to interface with a piezo transducer for communication of an ultrasonic signal to the conductive portion.

Optionally, the interconnection end of the conductive compliant pin comprises a press-fit arrangement to interconnect with the conductive portion of the PCB receptacle.

Optionally, the conductive compliant pin comprises two portions, a first portion comprising the interconnection end of the conductive compliant pin and a second portion comprising the piezo interface end of the conductive compliant pin, wherein the first portion comprises a thickness less than the second portion.

Optionally, the piezo interface end of the conductive compliant pin comprises a C-shape contact arranged to contact a piezo transducer.

Optionally the C-shape may contact the piezo transducer substantially in the centre of the piezo transducer.

Optionally, the first portion and the second portion of the conductive compliant pin are joined by one of riveting, clinching, laser welding or ultrasonic welding.

Optionally, the conductive compliant pin comprises the same thickness throughout its length.

Optionally, the piezo interface end of the conductive compliant pin comprises a ring-shape contact arranged to contact a piezo transducer substantially at the periphery of the piezo transducer.

According to a fifth aspect there is provided a method of providing a conductive compliant pin comprising an interconnection end arranged to complete a solderless joint with a conductive portion of a receptacle of a PCB and a piezo interface end arranged to interface with a piezo transducer for communication of an ultrasonic signal to the conductive portion.

Optionally, the method wherein the interconnection end of the conductive compliant pin comprises a press-fit arrangement to interconnect with the conductive portion of the PCB receptacle.

Optionally, the method wherein the conductive compliant pin comprises two portions, a first portion comprising the interconnection end of the conductive compliant pin and a second portion comprising the piezo interface end of the conductive compliant pin, wherein the first portion comprises a thickness less than the second portion.

Optionally, the method wherein the piezo interface end of the conductive compliant pin comprises a C-shape contact arranged to contact a piezo transducer.

Optionally, the C-shape contact may contact the piezo transducer substantially in the centre of the piezo transducer.

Optionally, the method further comprising joining the first portion and the second portion of the conductive compliant pin by one of riveting, clinching, laser welding or ultrasonic welding.

Optionally, the method wherein the conductive compliant pin comprises the same thickness throughout its length.

Optionally, the method wherein the piezo interface end of the conductive compliant pin comprises a ring-shape contact arranged to contact a piezo transducer substantially at the periphery of the piezo transducer.

With all the aspects, preferable and optional features are defined in the dependent claims.

### Brief Description of the Drawings

Embodiments will now be described, by way of example only, and with reference to the drawings in which:
- Figure 1: illustrates a plated through-hole of a solderless joint arrangement;
- Figures 2A to 2F: illustrate various flexible PCB examples;
- Figure 3: illustrates a two-piece conductive compliant pin;
- Figure 4: illustrates a one-piece conductive compliant pin; and
- Figures 5: illustrates a deformable interconnection end of a compliant pin.

In the figures, like elements are indicated by like reference numerals throughout.

### Detailed Description

As discussed in the background section, fretting corrosion occurs where there is movement of either the plated through-hole by way of PCB movement relative to a conductive element forming a solderless joint, or movement of the conductive element itself relative to the plated through-hole of the PCB.

A smaller motion between the moving features of the joint produces a smaller amount of oxidation debris, however, the debris is more likely to remain near the contact point(s) which may affect the conductivity of the joint more readily. A larger motion between the moving features of the joint is more likely to produce greater debris, however, the debris may be pushed further away from the contact point(s) and track of the fretting motion which may reduce the immediate impact of the debris on the reliability of the solderless joint. In a similar manner, lower forces between the conductive element and the plated through-hole will produce less wear but oxide debris may remain closer to the contact point, and higher forces may produce more debris, but move the debris further away from the contact point. Hence it is desirable to avoid movement between the plated through-hole and the conductive element.

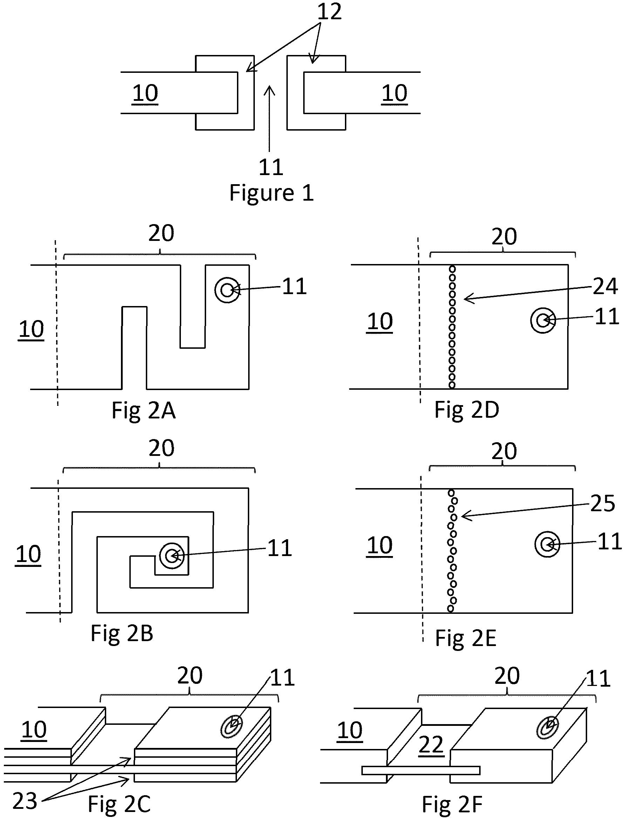

Turning to figure 1, a solderless joint arrangement is disclosed comprising a PCB 10 having a receptacle 11 to receive a conductive compliant pin (not shown in figure 1). Typically, the PCB comprises multi-layer FR4 material. Any suitable PCB material may be used. The receptacle 11 may be considered to be a through-hole, often referred to as via, of the PCB. The receptacle comprises a conductive portion 12 which is at least partially plated, and preferably completely plated with a conductive material such as copper, known as a plated through-hole (PTH). The plating 11 may be electrically coupled to a circuit of the PCB as would be understood.

Figure 2A illustrates that receptacle 11 is positioned on a portion 20 of the PCB 10 that is flexible. That is to say that the flexible portion 20 may flex in any or all of the three axis x, y and z. Flexibility of portion 20 of the PCB may be provided in a number of ways. Figures 2B to 2F show other examples of providing a flexible portion 20 of PCB 10. Figures 2A to 2C illustrate flexibility provided by cutting the PCB 10. Figure 2A shows a sine wave-shape cut 21, figure 2B shows a spiral-shape cut 22 and figure 2C shows the provision of a flexible 'hinge' by layers cut away 23 from the PCB to provide a weaker area that is able to flex. Layers 23 may also be removed alternatively or additionally by etching. Figure 2D illustrates providing a flexible 'hinge' by drilling a series of holes 24 into the PCB 10 to provide a weaker area of the PCB to provide the flexible portion. The whole of flexible portion 20 can be flexible as shown in figures 2A and 2B, or a smaller (hinge) portion can be flexible as shown in figures 2C to 2F. Cutting and/or etching of the PCB as well as holes 24 may be positioned in any shape or pattern to provide PCB 20 with a flexible portion of dimensions and flexibility suitable for the PCB footprint allowed in the device at issue. For example, holes 25 may comprise a zigzag pattern as shown in figure 2E. In a further example, flexible portion 20 may comprise rubber, plastic, thin metal or another flexible material 22 arranged in a hinge-type manner to join two pieces of PCB as shown in figure 2F. Flexible portion 20 of figure 2F may be coupled to the two pieces of PCB by way of glue, rivets or any other suitable joint.

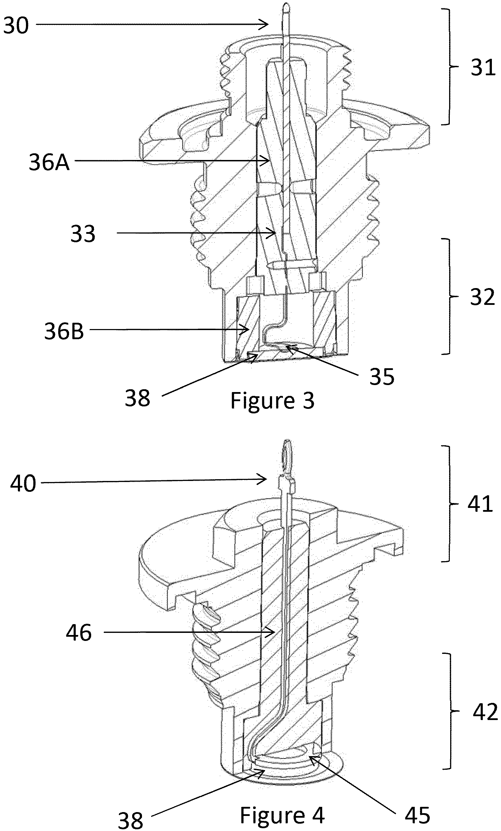

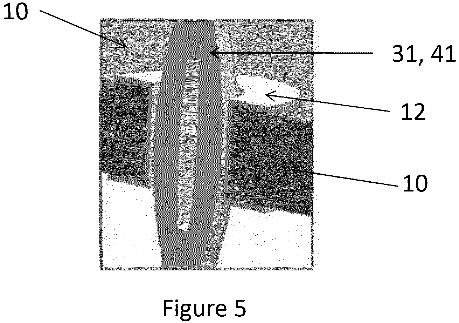

The solderless joint arrangement as described herein may also comprise a conductive compliant pin 30, 40 as shown in figures 3 and 4. An interconnection end 31, 41 is arranged to form a solderless joint with the conductive portion 12 by way of a press-fit or other arrangement in receptacle 11. For example, interconnection end 31 may comprise a deformable section such as that shown in figure 5 (and in figure 4) whereby the oval-shaped area is capable of deformation to form a smaller diameter and hence enter the receptacle 11 to make contact with conductive portion 12. Interconnection end 31, 41 may also comprise a hook (see figure 3) or other suitable deformable arrangement. In a non-deformed state, interconnection end 31, 41 comprises a dimension wider than that of the diameter of receptacle 11, hence deformation is required for the interconnection end 31, 41 to enter receptacle 11. Interconnection end 31, 41 may also comprise a tab or lip to prevent the interconnection end being inserted too far into receptacle 11 and hence passing through the receptacle without forming a solderless joint with conductive portion 12.

Conductive compliant pin 30, 40 also comprises an interface end 32, 42 preferably a piezo transducer interface end, for coupling with a piezo transducer 38 for communication of an ultrasonic signal to the conductive portion 12. The interconnection end 31 may comprise a different cross-sectional area (thickness) than that of interface end 32 as shown in figure 3 (conductive compliant pin 30) that is to say a first portion comprising the interconnection end and a second portion comprising the interface end comprise different cross-sectional areas

The first portion and the second portion may be joined 33 by way of riveting, clinching, laser welding or ultrasonic welding as would be understood.

Alternatively, the conductive compliant pin may comprise the same cross-sectional area (thickness) throughout its length as shown in figure 4 with conductive compliant pin 40.

Both the one piece 30 and the two-piece 40 compliant pin may be formed from CuSn6 (bronze). Alternatively, the second portion comprising the interface end 32 (spring-like portion as discussed later) of the two-piece compliant pin may be formed from CuBe2 or CuNiSn.

The conductive compliant pin may comprise a contact 35 arranged to contact a piezo transducer 38 as shown in figure 3 which may be a C-shape contact, or a contact 45 arranged to contact a piezo transducer 38 substantially at the periphery of the transducer as shown in figure 4. Contact 45 may be a ring-shape contact.

When it is desired to install a solderless joint, conductive compliant pin 30, 40 enters receptacle 11 such that interconnection end 31 resides at least partially within receptacle 11. Deformation of interconnection end 31 occurs in order that the widest dimension of interconnection end 31 is reduced for it to enter receptacle 11, preferably in a press-fit manner as would be understood. As receptacle 11 is positioned on flexible portion 20 of PCB 10, an opposing force, optionally provided by an installer or an installation tool on an appropriate area surrounding receptacle 11 resists the installation force of conductive compliant pin 30, 40 to allow the interconnection end 31, 41 of the pin to at least partially enter receptacle 11. When installed, conductive compliant pin 30, 40 forms a solderless joint with conductive portion 12.

Flexible portion 20 is able to flex and move by way of the shape, cut, drill holes or other arrangement as described in relation to figures 2A to 2F. Accordingly, movement of interconnection end 31, 41 relative to conductive portion 12 (and receptacle 11) is reduced, and preferably eliminated. This reduction or elimination of movement reduces or eliminates the build-up of loosened oxidation film and the subsequent rebuild-up of tin oxide as described in the background section (fretting corrosion). As a result, receptacle 11 and conductive portion 12 contain less or no debris that could affect the resistivity of the solderless joint and hence the solderless joint is more reliable than known solderless joints.

Returning to figure 3, conductive compliant pin 30 as shown comprises two portions with the interface end portion 32 being of a cross-sectional area (thickness) less than that of the interconnection end portion 31. Interface end portion 32, is arranged in a spring-like manner. A function of the thinner interface end 32 is to reduce a downward force on the interface end contact. In a typical installation, interconnection end 31 is uppermost with respect to interface end 32, and interface end 32 is coupled to a piezo transducer for the communication of an ultrasonic signal through the conductive compliant pin to the conductive portion 12 of PCB 10. As would be understood, any downward forces on the piezo transducer could affect the operation of the transducer, and could alter its frequency of operation. The spring-type function of the thinner interface end is therefore able to move and compensate for any forces both on and from the piezo transducer such that its frequency of operation is not affected by external influences. This avoids the need for other features being present to support the compliant pin in a static manner such as lips, tabs or other support features of the PCB or device in question designed to keep the compliant pin static and to avoid affecting the operation of the piezo transducer as would be understood.

As previously described, compliant pin 30 is of a two portion construction that requires riveting, clinching, laser welding or ultrasonic welding as would be understood. The arrangement of compliant pin 30 may also comprise an overmoulding 36A, 36B. The overmoulding has several functions. One to electrically isolate the conductive compliant pin from other parts of the device, two, to maintain the piezo contact in position, three, to avoid any stress on the piezo during compliant pin insertion, and four, to provide a support backing for the piezo transducer. When installed in a water meter (as would be understood), the piezo transducer may have a high pressure on the side opposite the compliant pin interface end, for example for a residential meter this may be up to 48bar (4800kPa). The overmoulding provides support to the piezo transducer so that the piezo is not distorted by the water pressure and maintains acceptable operation. With a two portion compliant pin as shown in figure 3, the overmoulding typically comprises two-part plastic mould 36A, 36B. One part 36A for the thicker portion of the compliant pin 31 and the other part 36B for the thinner portion 32, and also to provide support for the piezo transducer.

Turing to figure 4, it can be seen that the plastic overmoulding 46 is of a one-part construction, and the ring-shape contact 45 of the interface end 42 is of a thickness capable of supporting the piezo around the periphery in the same manner as the two-piece overmoulding of figure 3. It can be seen that the one-piece conductive contact pin of figure 4 allows a more simple overmoulding which simplifies manufacturing processes while maintaining ultrasonic communication with the conductive portion 11.

Compliant pin 30 or 40 may be used with a PCB comprising a flexible portion 20 as described herein in relation to figures 2A to 2F.

When the disclosed flexible portion 20 of PCB 10 and the one-piece conductive compliant pin as shown in figure 4 are used together, combined benefits are realised. The spring-type function of a two piece pin is provided, instead, by the flexible PCB portion 20 so that the compliant pin 40 remains static relative to the conductive portion 12 and hence the solderless joint does not degrade over time. Additionally, the conductive compliant pin does not need to provide any movement function for protection of the piezo transducer from external forces, therefore removing the necessity for the two-piece pin design. A more simple compliant pin construction and also a more simple overmoulding design are realised. All of these benefits allow reduced time, cost and complexity of design for the device within which the solderless joint and compliant pin will operate.

Accordingly an improved solderless joint arrangement has been disclosed.

## Claims

1. A solderless joint arrangement comprising:
a receptacle of a PCB arranged to receive a conductive compliant pin, the receptacle comprising a conductive portion for contact with the compliant pin; wherein
the receptacle is positioned within a flexible portion of the PCB.

2. The solderless joint of claim 1 wherein the receptacle comprises a plated through-hole.

3. The solderless joint of claim 1 or 2 wherein the flexible portion of the PCB is arranged to be flexible in at least one of the x, y and/or z axis; and optionally wherein the flexible portion of the PCB is arranged to be flexible in each of the x, y and z axis.

4. The solderless joint of any preceding claim wherein the flexible portion comprises drill holes to provide flexibility of the PCB.

5. The solderless joint of any preceding claim wherein the flexible portion comprises cuts to provide flexibility of the PCB; and optionally wherein the flexible portion comprises a spiral shape cut to the PCB to provide flexibility of the PCB.

6. The solderless joint of claim 4 wherein the flexible portion comprises the removal of at least one layer of the PCB to provide flexibility of the PCB.

7. The solderless joint of any preceding claim further comprising a conductive compliant pin positioned within the receptacle, the conductive compliant pin comprising:
an interconnection end arranged to complete the solderless joint with the conductive portion of the receptacle; and
a piezo interface end arranged to interface with a piezo transducer for communication of an ultrasonic signal to the conductive portion.

8. The solderless joint of claim 7 wherein the interconnection end of the conductive compliant pin comprises a press-fit arrangement to interconnect with the conductive portion of the PCB.

9. The solderless joint of any claim 7 or 8 wherein the conductive compliant pin comprises two portions, a first portion comprising the interconnection end of the conductive compliant pin and a second portion comprising the piezo interface end of the conductive compliant pin, wherein the second portion comprises a thickness less than the first portion.

10. The solderless joint of claim 9 wherein the piezo interface end of the conductive compliant pin comprises a C-shape contact arranged to contact a piezo transducer.

11. The solderless joint of claim 9 or 10 wherein the first portion and the second portion of the conductive compliant pin are joined by one of riveting, clinching, laser welding or ultrasonic welding.

12. The solderless joint of claim 7 or 8 wherein the conductive compliant pin comprises the same thickness throughout its length.

13. The solderless joint of claim 12 wherein the piezo interface end of the conductive compliant pin comprises a ring-shape contact arranged to contact a piezo transducer substantially at the periphery of the piezo transducer.

14. A water meter comprising the solderless joint of any preceding claim.

15. A method of providing a solderless joint arrangement as claimed in any of claims 1 to 13.
